# EUROPEAN PATENT APPLICATION

(11) **EP 0 949 464 A1**
(43) Date of publication of application: **13.10.1999**
(21) Application number: 97911485.7
(22) Date of filing: 07.11.1997
(51) Int. Cl.: F25B 21/02, F25D 11/00

(54) **THERMOELECTRIC MODULE-CONTAINING HEAT EXCHANGER UNIT AND THERMOELECTRIC COOLING SYSTEM**

(30) Priority: 08.11.1996 JP 29674996
(71) Applicant: MATSUSHITA REFRIGERATION COMPANY, Higashiosaka-shi, Osaka 577 (JP)
(72) Inventor: NAKAGAWA, Osamu, Kouka-gun, Shiga 520-32 (JP); MAEDA, Munekazu, Yao-shi, Osaka 581 (JP); KITAGAWA, Hiroaki, Otsu-shi, Shiga 520-21 (JP); TOKUNAGA, Shigetomi, Otsu-shi, Shiga 520-22 (JP)
(74) Representative: Eisenführ, Speiser & Partner
(86) International application number: JP9704063
(87) International publication number: WO9821532

(57) **Abstract**

A plurality of series-connected heat exchanger units (50, 51, 52) are provided with thermoelectric modules (5), and turbulators (55) are provided on both surfaces of these thermoelectric modules (5). Each of the turbulators (55) is covered with a lower shell (53) or an upper shell (54), whereby a heating medium passes between the termoelectric modules (5) and turbulators (55). The lower shell (53), upper shell (54) and turbulators (55) are formed out of a transparent material so that the interior of the heat exchanger units can be visually observed.

## Description

### Technical Field

The present invention relates to a heat-exchanger unit having a thermoelectric module built therein, and a refrigerating system utilizable in an electric refrigerator of a type including the thermoelectric module.

### Background Art

Ozonosphere degradation resulting from emission of Freon gases has recently drawn public attention, and the development of a cooling device that does not use any gaseous Freon is now pressingly needed. A cooling device utilizing a thermoelectric module is promising as a cooling device that does not use any gaseous Freon.

The thermoelectric module is generally known as a Peltier module or a thermoelectric heat module and is of a design including two heat transfer surfaces which are, when an electric current flows, heated and cooled, respectively.

A refrigerating device utilizing the thermoelectric module is disclosed, for example, in Japanese Laid-open Patent Publication No. 6-504361.

The invention disclosed in Japanese Laid-open Patent Publication No. 6-504361 includes a heat-exchanger unit having a thermoelectric module built therein and also having two cavities formed on respective sides of the thermoelectric module. One of the cavities which confronts a hot-side heat transfer surface of the heat-exchanger unit is fluid-connected with a closed fluid circuit comprised of a heat-exchanger and a pump, whereas the other of the cavities confronting a cold-side heat transfer surface of the heat-exchanger unit is fluid-connected with a closed fluid circuit similarly comprised of a heat-exchanger and a pump. In this way, a circulation circuit including the hot-side heat transfer surface of the thermoelectric module and a circulation circuit including the cold-side heat transfer surface of the thermoelectric module are formed so that a heat transfer medium can be circulated between those circulation circuits. The heat-exchanger included in one of the circulation circuits which serves as a refrigerating fluid circuit is utilized to accomplish a desired refrigeration.

The invention according to the above mentioned prior art is a practical technology to accomplish the refrigeration by the use of the thermoelectric module. However, this prior art literature merely discloses the fundamental of the refrigerating device and does therefore leave a substantial number of problems to be solved and/or improved in order for the prior invention to be actually employed in electric refrigerators or the like.

The present invention provides a technology for improvement of the heat-exchanger unit out of the number of the problems and has for its object to provide an improved heat-exchanger unit, and a thermoelectric refrigerating system, having built therein a thermoelectric module which is improved in respect of productivity, maintenance and component compatibility.

### Disclosure of the Invention

To accomplish this and other objects, the heat-exchanger unit with built-in thermoelectric module according to the present invention is characterized in that it comprises a thermoelectric module having at least two heat transfer surfaces which are, when an electric current flows, heated and cooled, respectively, and a shell member for covering at least one of the heat transfer surfaces of the thermoelectric module to define, between it and such one of the heat transfer surfaces, a cavity for passage of a heat transfer medium therethrough, said shell member being transparent or semi-transparent.

Since the shell member is transparent or semi-transparent, the state of flow of the heat transfer medium inside can be viewed from the outside.

With due regards paid to the problems inherent in the prior art, the function of the present invention will now be discussed.

In the refrigerating device utilizing the thermoelectric module, a direct heat-exchange takes place between any one of the heat transfer surfaces of the thermoelectric module and the heat transfer medium. For this reason, the refrigerating device utilizing the thermoelectric module has its refrigerating performance which is considerably affected by the flow of the heat transfer medium within the heat-exchanger unit. In particular, entry of air into the heat-exchanger unit should stringently be avoided.

Accordingly where the refrigerating device utilizing the thermoelectric module is to be incorporated in a refrigerator or the like, it is necessary to ascertain if the heat-exchanger unit contains entangled air. However, with the prior art technology, it has been impossible to ascertain the presence or absence of air inside the heat-exchanger unit with no difficulty. For this reason, assemblage of the refrigerator and injection of the heat transfer medium have required utmost care, involving reduction in workability.

According to the present invention, however, since the transparent or semi-transparent shell member is employed, the flow of the heat transfer medium within the heat-exchanger unit can be easily viewed from the outside. Accordingly, after the heat-exchanger unit has been installed in the refrigerator, the presence or absence of air entangled in the heat-exchanger unit can easily be ascertained and, therefore, the heat transfer medium can be injected with no care required, accompanied by increase in workability.

Also, even when the refrigerator is to be serviced and inspected, the need to ascertain the presence or absence of air in the heat-exchanger unit is strongly desired. More specifically, the refrigerating device utilizing the thermoelectric module is so simple in structure that locations where fault occurs in the heat-exchanger unit are limited. Most troubles appear to result from a fault in a pump for circulating the heat transfer medium, leakage of the heat transfer medium, and/or occlusion taking place inside the heat-exchanger unit.

According to the present invention, however, since the flow of the heat transfer medium within the heat-exchanger unit can be observed with naked eyes, the trouble can easily be located. For example, if the heat transfer medium fail to circulate within the heat-exchanger unit, the pump may be suspected as failing to operate properly; if the presence of bubbles is located within the heat-exchanger unit, the heat transfer medium may be suspected as leaking; and if the heat transfer medium is partly stagnated within the heat-exchanger unit, occlusion may be suspected as occurring within the heat-exchanger unit.

The heat-exchanger unit according to another embodiment of the present invention is characterized in that it comprises a thermoelectric module having at least two heat transfer surfaces which are, when an electric current flows, heated and cooled, respectively, a shell member for covering one of the heat transfer surfaces of the thermoelectric module that is heated, to thereby define a cavity for passage of a heat transfer medium therethrough between it and the heated heat transfer surface of the thermoelectric module, and a cooling plate held in contact with one of the heat transfer surface of the thermoelectric module which is cooled, said cooling plate being utilizable for the support thereon of an article to be cooled.

With this structure, the heat transfer medium such as, for example, water, absorbs heat from the hot-side heat transfer surface when the heat transfer medium flows through the cavity. As a result, the temperature of the cold-side heat transfer surface is lowered, accompanied by lowering of the temperature of the cooling plate to cool the article directly through the cooling plate.

Preferably, the cooling plate is of a structure replaceable with the shell member so that, when the cooling plate is replaced with the shell member, the cavity for passage of the heat transfer medium therethrough can be defined adjacent each of the heat transfer surfaces.

With this structure, a member common to the shell member that covers the hot-side heat transfer surface can be employed to thereby enhance component compatibility.

Also, if a sealing member is interposed between the shell member and the heat transfer surface, the possibility of the heat transfer medium leaking from the cavity can be avoided.

The heat-exchanger unit according to a further embodiment of the present invention is characterized in that it comprises a thermoelectric module having at least two heat transfer surfaces which are, when an electric current flows, heated and cooled, respectively, a shell member for covering at least one of the heat transfer surfaces of the thermoelectric module to define a cavity for passage of a heat transfer medium therethrough between it and such one of the heat transfer surfaces of the thermoelectric module, said shell member having a lead insertion hole defined therein in communication with the outside, and an elastic seal member having a through-hole defined therein and inserted in the lead insertion hole, said thermoelectric module having a lead wire that is inserted through the through-hole in the elastic seal member so as to extend externally from the shell member, said elastic seal member being compressed when the lead wire is passed therethrough, to thereby compress the lead insertion hole and the lead wire.

In the heat-exchanger unit having the thermoelectric module built therein, it is important to prevent the heat transfer medium from being leaked. However, in the prior art heat-exchanger unit, the lead wire extending from the thermoelectric module must be drawn out of the shell member and difficulty has hitherto been encountered with in sealing a region at which the lead wire is drawn outside.

According to the present invention, not only is the lead wire clamped in a compressed fashion by the elastic seal member, but also the elastic seal member compresses the lead insertion hole, and therefore, no leakage of the heat transfer medium take place from the region where the lead wire is drawn outwardly. Accordingly, the frequency of servicing and inspection needed can be reduced.

The heat-exchanger unit according to a still further embodiment of the present invention is characterized in that it comprises a thermoelectric module having at least two heat transfer surfaces which are, when an electric current flows, heated and cooled, respectively, and a shell member for covering at least one of the heat transfer surfaces of the thermoelectric module to define a cavity for passage of a heat transfer medium therethrough, a hollow portion being integrally provided at a rear side of the cavity in the shell member.

The heat-exchanger unit having the thermoelectric module built therein requires a heat insulation to avoid dissipation of heat. According to the prior art, after the heat-exchanger unit has been installed inside a refrigerator or the like, glass wool or the like is wrapped around the heat-exchanger unit to avoid any possible dissipation of heat from the heat-exchanger unit. However, a job of wrapping the heat-exchanger unit with glass wool or the like is time-consuming and requires skill. Also, when it comes to dismantling of the heat-exchanger unit during the servicing and inspection, the glass wool must be unwrapped piece-by-piece, requiring a cumbersome procedure.

According to the present invention, however, no insulation is required and it is, therefore, possible to provide the heat-exchanger unit that can easily be installed in the refrigerator and with which servicing and inspection can easily be accomplished.

In other words, in the heat-exchanger unit according to the present invention, the hollow portion formed integrally on the rear side of the cavity in the shell member functions as a heat insulating layer. Accordingly, the shell member and the heat insulating layer are integrated together to facilitate installation into the refrigerator and the servicing and inspection.

Also, injection of a foam material into the hollow portion is effective to increase the heat insulating property.

The present invention also provides a heat-exchanger unit assembly having the thermoelectric module built therein, which is characterized in that it comprises a plurality of blocks each comprising a thermoelectric module having at least two heat transfer surfaces which are, when an electric current flows, heated and cooled, respectively, and a shell member for covering at least one of the heat transfer surfaces of the thermoelectric module to define a cavity for passage of a heat transfer medium therethrough, said shell member being provided with a tubular connector, said blocks being connected together with the tubular connector of the shell member of one of the blocks fluid-connected with the tubular connector of the shell member of the next adjacent one of the blocks to thereby define a continuous flow passage.

With the prior art heat-exchanger unit having the thermoelectric module built therein, the heat-exchanging performance is fixed and, therefore, a particular heat-exchanger must be designed for a particular capacity of the refrigerator or the like. Also, according to the prior art, even the thermoelectric module to be built in the heat-exchanger unit must be designed for a particular capacity of the refrigerator or the like. For this reason, there has been encountered with the lack of compatibility of component parts and difficulty in servicing and inspection.

In view of this, the present invention is to provide the heat-exchanger unit that can be used for any capacity of the refrigerator or the like and also to increase the component compatibility.

More specifically, the heat-exchanger unit according to the present invention is in the form of an assembly including a plurality of blocks connected at their connectors with each other to define the continuous flow passage and, accordingly, by varying the number of the blocks to be connected, the capacity can be changed.

According to a yet further embodiment of the present invention, the heat-exchanger unit assembly is characterized in that it comprises a plurality of blocks each comprising a thermoelectric module having at least two heat transfer surfaces which are, when an electric current flows, heated and cooled, respectively, and a shell member for covering at least one of the heat transfer surfaces of the thermoelectric module to define a cavity for passage of a heat transfer medium therethrough, said shell member being provided with an electric connector for connection with the thermoelectric module, said blocks being electrically connected with each other through the connectors.

Where the heat-exchanger unit is separated into a block, it is preferred that the thermoelectric modules are electrically connected in series with each other.

In the heat-exchanger unit assembly of the present invention, since the connector electrically connected with the associated thermoelectric module is provided in the shell member, connection of the respective connectors of the neighboring blocks facilitates an electric connection and installation into the refrigerator or the like and servicing and inspection can easily be accomplished.

Also, if a tubular connector is provided in the shell member, a continuous flow passage can be formed merely by coupling the connectors to thereby connect the blocks together.

According to a different embodiment of the present invention, the heat-exchanger unit assembly is characterized in that each of the blocks comprises a thermoelectric module having at least two heat transfer surfaces which are, when an electric current flows, heated and cooled, respectively, and a shell member for covering at least one of the heat transfer surfaces of the thermoelectric module to define a cavity for passage of a heat transfer medium therethrough, wherein the cavities in those blocks are fluid-connected parallel to each other.

With this structure, since the plural blocks are connected parallel to each other, the resistance to flow is low. Also, where the heat-exchanger units are connected in series with each other, there is the possibility that clogging on one heat-exchanger unit results in a complete loss of the refrigerating capability, but where they are connected parallel to each other, the refrigerating power can be secured to a certain extent. For this reason, the heat-exchanger unit assembly of the present invention is effective to secure more or less a time needed for servicing and, therefore, servicing and inspection can easily be performed.

The present invention furthermore provides a thermoelectric refrigerating system in which a heat-exchanger for refrigerating an article to be cooled, a pump for circulating a heat transfer medium and a first heat-exchanger unit having a first thermoelectric module built therein, said heat-exchanger, pump and first heat-exchanger unit being connected in a ring-shaped fashion, in which there is provided a shell member for covering a hot-side heat transfer surface of a second thermoelectric module and for defining a cavity for passage of the heat transfer medium therethrough between it and the hot-side heat transfer surface of the second thermoelectric module, and a second heat-exchanger unit including a cooling plate held in contact with a cold-side heat transfer surface of the second thermoelectric module for providing the article partly with a region o a low temperature.

With the prior art thermoelectric refrigerating system, the article is refrigerated by means of a heat exchange accomplished merely by the thermoelectric module and it has therefore been difficult to further reduce the temperature of a particular region of the article to be cooled. Accordingly, an electric refrigerator utilizing such thermoelectric refrigerating system is unable to lower the temperature inside a cabinet down to a value required for icing and, therefore, no ice can be prepared.

With the thermoelectric refrigerating system of the present invention, not only the refrigerating power of the electric refrigerator utilizing the thermoelectric module, but also the icing capability can be increased. In other words, although the interior of the cabinet is cooled as is the case with the standard refrigerator, the hot-side heat transfer surface of the thermoelectric module can also be cooled by the heat transfer medium flowing through the heat-exchanger. Because of this, the cold-side heat transfer surface of the thermoelectric module is cooled to a temperature lower than the temperature at a surface of the heat-exchanger used to cool the interior of the cabinet, resulting in creation of a region of a low temperature partly inside the cabinet.

### Brief Description of the Drawings

Fig. 1 is a diagram showing a refrigerating cycle of an electric refrigerator employing a thermoelectric refrigerating system according to the present invention;
Fig. 2 is a perspective view of the refrigerator shown in Fig. 1;
Fig 3 is a longitudinal sectional view of the refrigerator shown in Fig. 2;
Fig. 4 is a rear view of the refrigerator shown in Fig. 2 with a rear plate removed;
Fig. 5 is an exploded view of a heat-exchanger unit assembly having a built-in thermoelectric module provided in the refrigerator;
Fig. 6 is a cross-sectional view taken along the line A-A in Fig. 5;

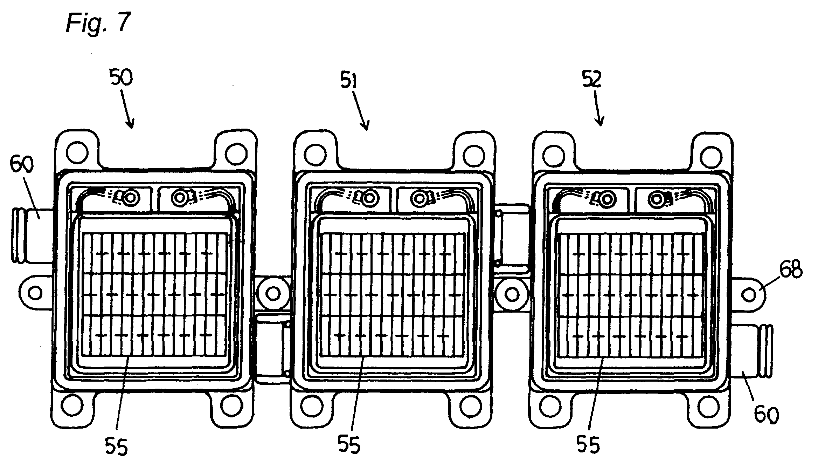

Fig. 7 is a plan view showing an interior of the heat-exchanger unit assembly shown in Fig. 5;
Fig. 8 is an exploded view of one of heat-exchanger units forming the heat-exchanger unit assembly shown in Fig. 5;
Fig. 9 is a perspective view of a turbulator built in the heat-exchanger unit;
Fig. 10 is a fragmentary perspective view, on an enlarged scale, of the turbulator shown in Fig. 9;
Fig. 11 is a fragmentary perspective view, on an enlarged scale, of the heat-exchanger unit shown in Fig. 8;
Fig. 12A is a sectional view, on an enlarged scale, showing how a lead wire is drawn outwardly from the heat-exchanger unit;
Fig. 12B is a sectional view, on an enlarged scale, showing the lead wire after having been drawn outwardly from the heat-exchanger unit;
Fig. 13A is a perspective view showing a connection between the neighboring heat-exchanger units;
Fig. 13B is a perspective view showing a modified form of the connection between the neighboring heat-exchanger units;
Fig. 14 is a sectional view showing a connection between tubular connectors of the respective heat-exchanger units;
Fig. 15 is a sectional view showing the heat-exchanger unit used in an ice-making chamber:
Fig. 16 is an exploded view of the heat-exchanger unit shown in Fig. 15;
Fig. 17 is a plan view of the heat-exchanger unit assembly according to a different embodiment of the present invention;
Fig. 18 is a sectional view of a connector used in the heat-exchanger unit assembly shown in Fig. 17;
Fig. 19 is a sectional view of the heat-exchanger unit according to a further embodiment of the present invention; and
Fig. 20 is a block diagram showing a still further embodiment of the present invention employing a different form of connection.

### Best Mode For Carrying out the Invention

Preferred embodiments of the present invention are described hereinafter with reference to the drawings.

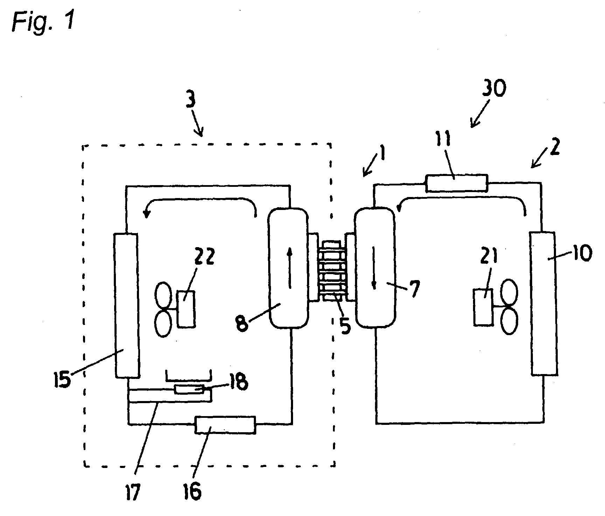

Fig. 1 depicts a refrigerating cycle of an electric refrigerator 30 employing a thermoelectric refrigerating system according to the present invention.

As shown in Fig. 1, the electric refrigerator 30 includes a hot-side piping system 2 and a cold-side piping system 3 both connected with each other via a heat-exchanger unit assembly 1 accommodating a thermoelectric module. A heat transfer medium circulates within each of the piping systems 2, 3. It is preferred that an antifreeze such as, for example, propylene glycol be added to the heat transfer medium accommodated in the cold-side piping system 3 to avoid freezing. Although water is preferred for the heat transfer medium because of a large specific heat water has, any other suitable liquid may be used for the heat transfer medium.

Each of the heat-exchanger units constituting the heat-exchanger unit assembly 1 accommodates therein a thermoelectric module 5 comprised of a Peltier element that will be described later. The heat-exchanger unit has two cavities 7, 8 formed on respective sides of the thermoelectric module 5.

The hot-side piping system 2 is a closed circuit including a heat-exchanger 10, a pump 11 and the cavity 7.

Similar to the hot-side piping system 2, the cold-side piping system 3 ia a closed circuit including a heat-exchanger 15, a pump 16 and the cavity 8. In the cold-side piping system 3, however, a bypass piping 17 connected to an ice-making heat-exchanger 18 is provided on a downstream side of the heat-exchanger 15. The heat-exchangers 10, 15 in the piping systems are cooled by respective fans 21, 22.

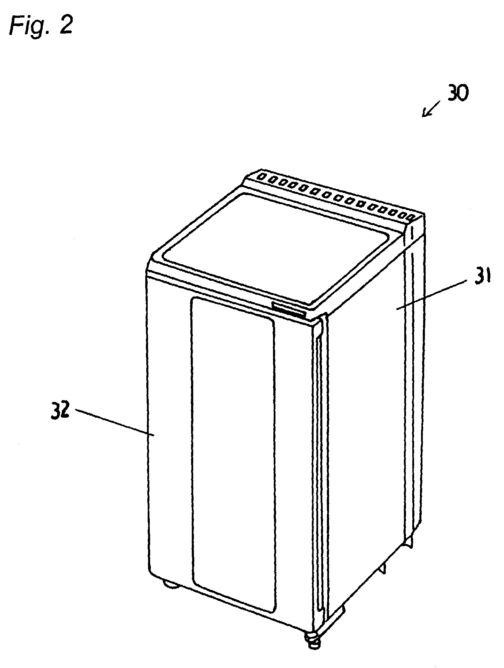

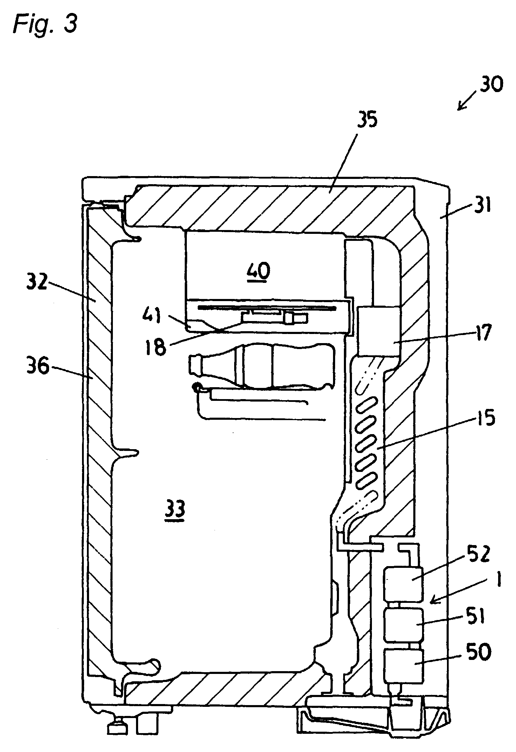

The structure of the refrigerator in this embodiment will be described hereinafter. Fig. 2 depicts an external appearance of the refrigerator 30, which is similar to that of the known ones. That is, the refrigerator 30 includes a box-shaped body 31 and a door 32 mounted on the front face thereof. As in the known refrigerators, the body 31 and the door 32 of the refrigerator accommodate heat insulating materials 35, 36 (see Fig. 3) and altogether define a closed storage compartment 33.

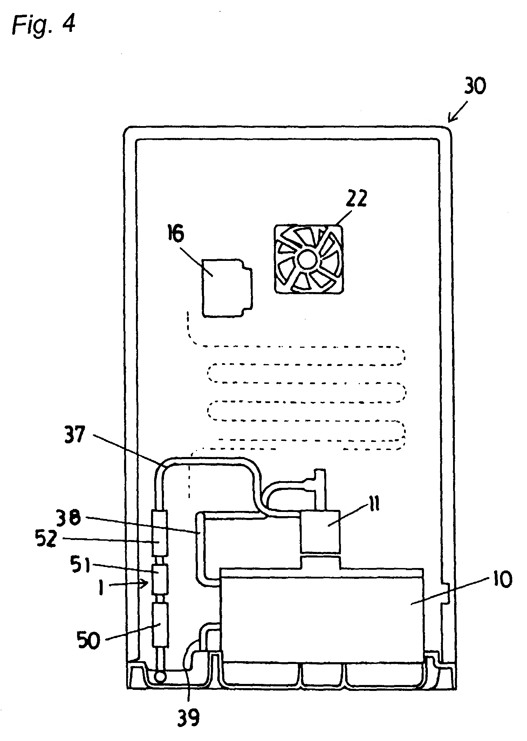

The pipings of the refrigerating system described above are arranged appropriately within or outside the heat insulating materials 35, 36. More specifically, as shown in Figs. 3 and 4, the heat-exchanger unit assembly 1 that forms the core of the refrigerating system is provided outside the storage compartment 33 defined by the heat insulating materials 35, 36, and is positioned at a lower right portion of the refrigerator 30 on the rear side thereof (as viewed from the door). The hot-side piping system 2 is provided outside the storage compartment defined by the heat insulating materials 35, 36, and is concentrated on the rear side of the refrigerator 30. The pump 11 and the heat-exchanger 10 are mounted in the proximity of the center at a lower portion of the refrigerator on the rear side thereof. The heat-exchanger unit assembly 1, the pump 11 and the heat-exchanger 10 are connected to one another by pipings 37, 38, 39 so as to form a loop.

On the other hand, the majority of the cold-side piping system 3 is arranged within the storage compartment 33 surrounded by the heat insulating materials 35, 36. More specifically, the heat-exchanger 15 is positioned inside the storage compartment 33 at the center thereof, while the pump 11 is positioned inside the storage compartment 33 at an upper right portion thereof. Also, a shelf portion 41 is mounted inside the storage compartment 33 and an ice-making heat-exchanger unit 18 is accommodated in the shelf portion 41. An ice-making chamber 40 is defined above the shelf portion 41.

Of the component parts explained hereinabove, the pumps 11, 16, the heat-exchangers 10, 15, the fans 21, 22 and the heat insulating structures of the refrigerator itself are quite the same as those used in the known refrigerators. The construction of the refrigerator 30 in this embodiment is characterized by the structure of the heat-exchanger unit assembly 1 and that of the ice-making heat-exchanger unit 18. Therefore, such structures will be mainly described hereinafter.

The heat-exchanger unit assembly 1 that forms the core of the refrigerating cycle will first be explained. As shown in Figs. 3, 4 and 5, the heat-exchanger unit assembly 1 employed in this embodiment is of a triple in-line design in which three blocks each having one heat-exchanger unit are connected together. That is, the heat-exchanger unit assembly 1 employed in this embodiment includes three heat-exchanger units 50, 51, 52 connected in series with each other and each accommodating the thermoelectric module 5. Of these three heat-exchanger units 50, 51, 52, the heat-exchanger units 50, 52 positioned on opposite sides are identical in shape and structure. Although the central heat-exchanger unit 51 has a fundamental structure similar to that positioned on opposite sides, the manner in which they are connected to each other or the mating structures thereof differ.

The heat-exchanger unit 50 is of the following structure.

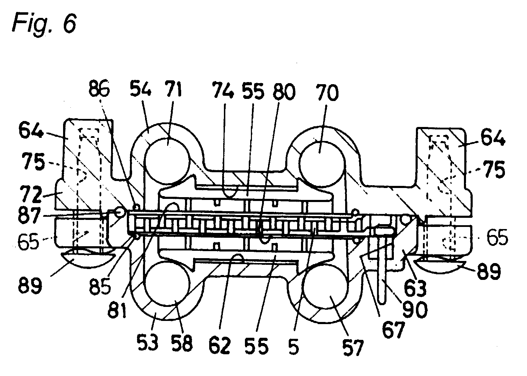

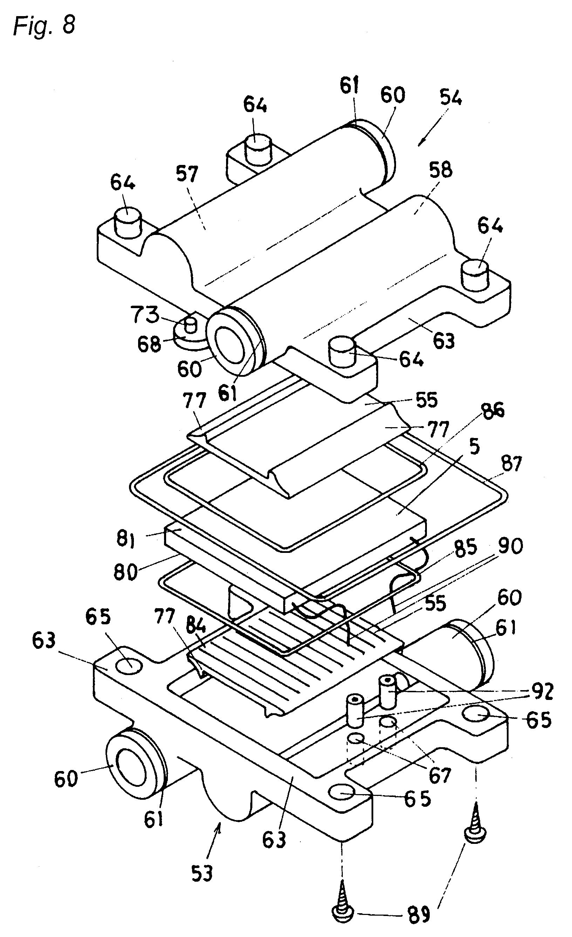

As shown in Figs. 6 and 8, the heat-exchanger unit 50 includes a lower shell 53, an upper shell 54, two turbulators 55, and a thermoelectric module 5.

The lower shell 53 has two hollowed projections extending parallel to each other and having respective flow passages 57, 58 defined therein. The two flow passages 57, 58 have a round section and are formed along opposite sides of an internal space defined in the lower shell 53 so as to extend in parallel to each other in a direction of connection of the three blocks. The flow passages 57, 58 are formed continuously from one end of the lower shell 53 to the other end thereof. Each of the flow passages 57, 58 has one closed end and the other end connected to a male coupler 60. More specifically, the flow passage 57 on the right-hand side of Fig. 6 has a closed front end and an open rear end connected to the male coupler 60, while the flow passage 58 on the left-hand side of Fig. 6 has a closed rear end and an open front end connected to the male coupler 60. That is, the closed end and the open end, to which the male coupler 60 is connected, of the flow passage 57 are the reverse to those of the flow passage 58.

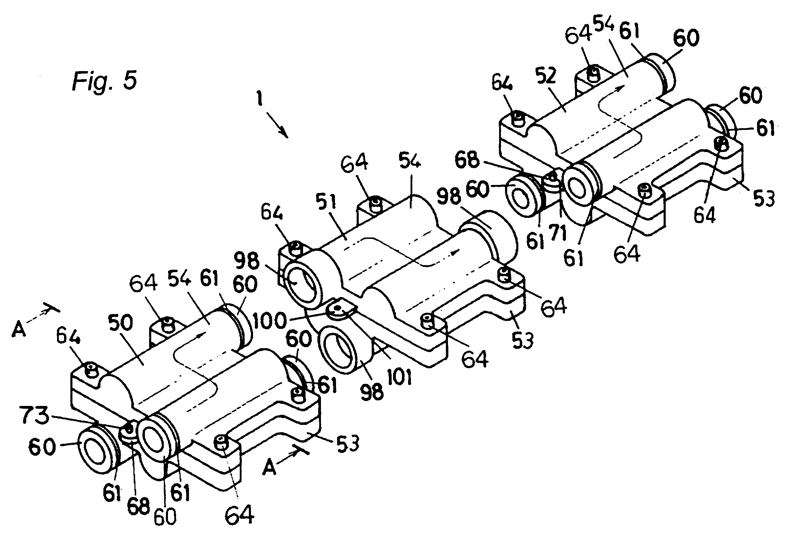

As shown in Figs. 5, 8 and 14, the male coupler 60 is a pipe-shaped coupler projecting from one end of the shell and has an O-ring 61 mounted thereon in the proximity of one end thereof.

A wall portion 62 (see Fig. 6) extends between the flow passages 57, 58. Flange portions 63 are provided externally of the flow passages 57, 58. A cavity through which the heat transfer medium passes is formed between the wall portion 62 mentioned above and the thermoelectric module 5. For this purpose, the wall portion 62 is formed internally of the flange portions 63. The flange portions 63 have four through-holes 65 defined therein, each of which has a screw threaded thereto.

The flange portions 63 of the lower shell 53 have two holes 67 defined therein for passage of lead wires therethrough, as described later (see Fig. 6).

The upper shell 54 is of substantially the same structure as the lower shell 53 and has two hollowed projections having respective flow passages 70, 71. Each of the flow passages 70, 71 has one closed end and one open end to which a male coupler 60 is connected for communication with the outside. A wall portion 74 is formed internally of flange portions 72 so as to extend between the flow passages 70, 71.

As shown in Fig. 8, the closed end and the open end, to which the male coupler 60 is connected, of each of the flow passages 70, 71 of the upper shell 54 are the reverse to those of the lower shell 53, when the two shells face to each other.

The flange portions 72 of the upper shell 54 have respective bosses 64 each having a screw hole 75 defined therein.

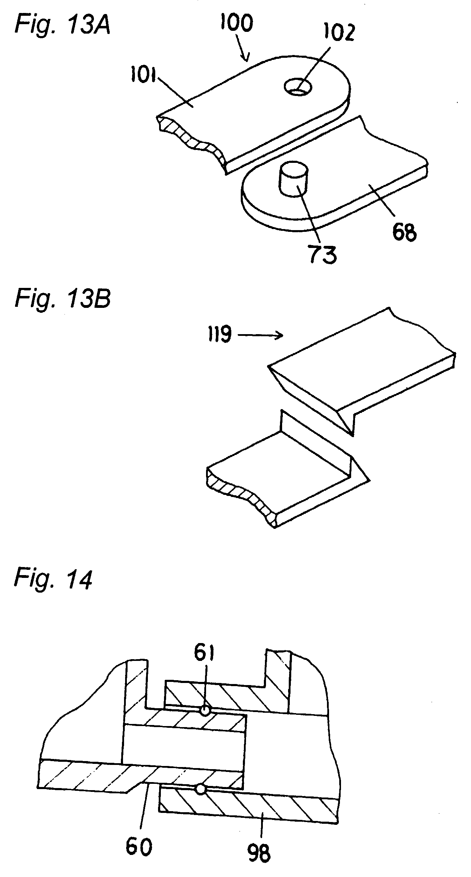

The upper shell 54 also has male connectors 68 formed on respective opposite ends thereof. As shown in Figs. 8 and 13A, each male connector 68 is made of a plate-like member extending from the upper shell 54 in parallel thereto and a pin 73 formed thereon. The upper shell 54 does not have any holes corresponding to the holes 67 for passage of lead wires.

Although the lower shell 53 and the upper shell 54 are formed of a thermoplastic resin by any known method such as, for example, an injection molding technique or the like, it is preferred that each of the lower shell 53 and the upper shell 54 is transparent or semi-transparent.

Material for the lower shell 53 and the upper shell 54 is not limited to a specific one, and any suitable material can be used if it is transparent or semitransparent. By way of example, a polystyrene resin, an ABS resin, a methacrylic resin, a polyvinyl chloride, a polyethylene terephthalate resin, a polybutylene terephthalate resin, a urea resin, a melamine resin, a chlorinated polyethylene resin, a vinylidene chloride resin, an acryl/vinyl chloride copolymer resin, a polymethylpentene resin, a polysulfone resin, a polyvinylidene fluoride resin, a MBS resin, a methacryl/styrene copolymer resin, a polyarylate resin, a polyaryl sulfone resin, a polybutadiene resin, a polyether sulfone resin, a polyether ether ketone resin or the like can be used. In particular, the use of a polyolefin resin is preferred.

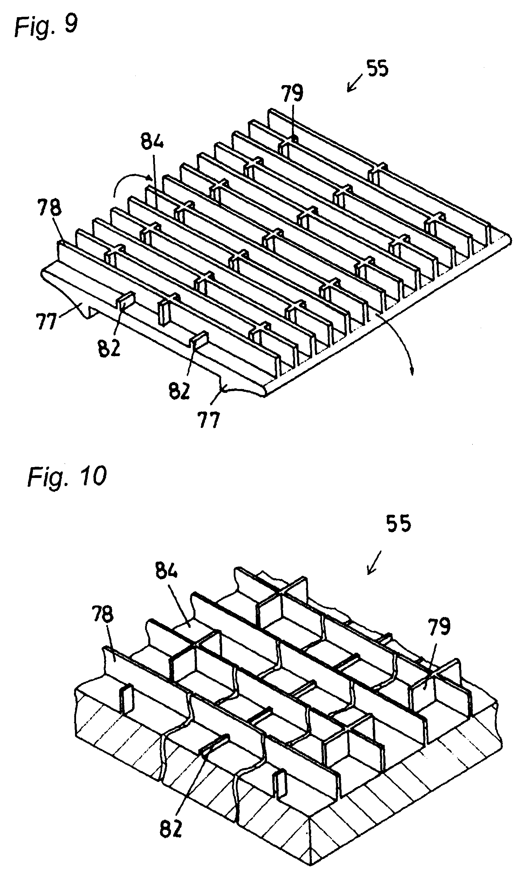

The turbulator 55 is in the form of a plate as shown in Fig. 9 and has two leg portions 77 formed on one surface thereof (the lower portion in the figure) for positioning thereof.

A large number of walls 78 forming flow passages are formed on the other surface (the upper portion in the figure) of the turbulator 55. Each of the walls 78 extends continuously from one end to the other end of the turbulator 55. The walls 78 are spaced at regular intervals and extend parallel to each other. Two neighboring walls 78 form one flow passage 84 in the form of a parallel groove. The turbulator 55 employed in this embodiment also has obstacles formed in each flow passage 84.

Specifically, the obstacles are projections 82 and baffles 79. The projections 82 are lower than the walls 78 and extend continuously in a direction perpendicular to the walls 78. In this embodiment, the projections 82 are formed in two rows.

The baffles 79 have the same height as the walls 78, but each of them is formed discontinuously. Each baffle 79 does not completely block the corresponding flow passage 84, and a gap is present in a direction widthwise of the flow passage 84. Some of the walls 78 have one baffle 79 formed on each surface thereof at the center in a direction longitudinally thereof, while the walls 78 next to those walls 78 have two baffles 79 formed on each surface thereof in the proximity of opposite ends thereof. Thus, the baffles 79 are formed in a zig-zag fashion with respect to the groove-shaped flow passages 84. Each of the projections 82 is interposed between the baffles 79.

The turbulators 55 are formed of a thermoplastic resin by a known method such as, for example, an injection molding technique, but the molding method is not limited to any specific one. In this embodiment, the turbulators 55 are transparent or semi-transparent, as is the case with the lower shell 53 and the upper shell 54. Material for the turbulators 55 may be the same as that used for the lower shell 53 and the upper shell 54, but the use of a transparent or semi-transparent polyolefin resin is particularly preferred.

The thermoelectric module 5 employs a known Peltier element having a P-type semiconductor and an N-type semiconductor arranged side by side. The thermoelectric module 5 has a plate-like external appearance and opposite surfaces that function as heat transfer surfaces 80, 81.

The construction of the heat-exchanger unit 50 is explained hereinafter. The heat-exchanger unit 50 has a thermoelectric module 5 at the center thereof, on opposite surfaces of which respective turbulators 55 are located. External surfaces of the turbulators 55 are covered with the lower shell 53 and the upper shell 54, respectively, both of which are connected together by screws 89.

The positional relationship among the lower shell 53, the upper shell 54, and the turbulators 55 is such as shown in Fig. 6, in which the turbulators 55 are mounted on the wall portions 62, 74 of the lower shell 53 and the upper shell 54, and the leg portions 77 are in engagement with side surfaces of the flow passages 57, 58 or the flow passages 70, 71. The walls 78 of the turbulators 55 extend in a direction perpendicular to the flow passages 70, 71. Thus, the flow passages 70, 71 communicate with each other over the entire surface of the thermoelectric module via the groove-shaped flow passages formed by the walls 78. The walls 78 of each turbulator 55 adjoin the heat transfer surface 80 or 81 of the thermoelectric module 5 so that a cavity for the passage of the heat transfer medium is formed between the surface of the turbulator 55 and the heat transfer surface 80 or 81 of the thermoelectric module 5.

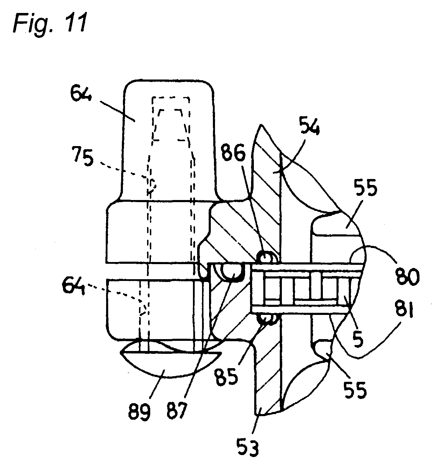

To describe the details, as shown in Figs. 8 and 11, a ring-shaped sealing member 85 or 86 is interposed between the heat transfer surface 80 or 81 of the thermoelectric module 5 and the shell 53 or 54 to prevent leakage of the heat transfer medium from the cavity through which the heat transfer medium passes. Another ring-shaped sealing member 87 is interposed between the lower shell 53 and the upper shell 54 at a location externally of the sealing members 85, 86 to prevent the heat transfer medium from leaking from the heat-exchanger unit 50 itself. That is, in this embodiment, double liquid sealing is achieved by the sealing members 85, 86 and by the sealing member 87.

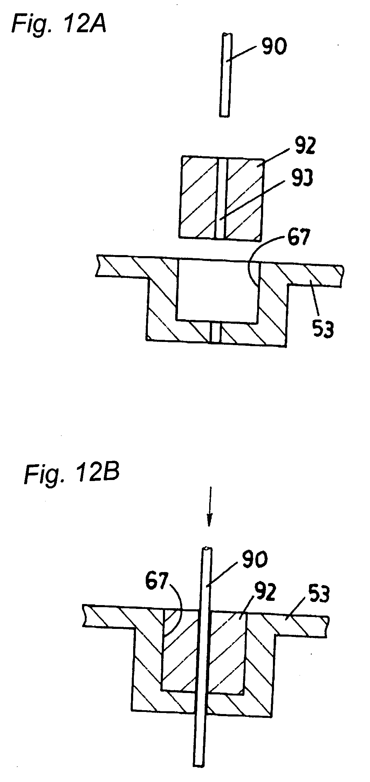

Each of the lead wires 90 of the thermoelectric module 5 is a single line and is led outside through the corresponding hole 67, the details of which are depicted in Fig. 12A. More specifically, the lead-wire hole 67 has stepped portions and includes a large-diameter portion on the inner side of the lower shell 53 and a small-diameter portion leading to the outside.

An elastic sealing member 92 made of, for example, rubber is inserted into the inner side, i.e., the large-diameter portion of the lead-wire hole 67. The elastic sealing member 92 is of a columnar shape and has a through-hole 93 defined therein at the center thereof. The external diameter of the sealing member 92 is originally substantially the same as the internal diameter of the inner side of the lead-wire hole 67, while the internal diameter of the through-hole 93 of the sealing member 92 is smaller than the external diameter of the lead wire 90.

As shown in Figs. 12A and 12B, the lead wire 90 is forcibly inserted into the through-hole 93 after the sealing member 92 has been inserted into the lead-wire hole 67. As a result, the elastic sealing member 92 is increased in diameter to accommodate compressive stresses which in turn press the sealing member 92 outwardly against the internal surface of the lead-wire hole 67 so that the sealing member 92 and the lead-wire hole 67 may be held in close contact with each other. Also, the elastic sealing member 92 and the lead wire 90 are held in close contact with each other under pressure.

Another heat-exchanger unit 51 will be explained hereinafter. Because the heat-exchanger unit 51 is fundamentally the same in construction as the above-described heat-exchanger unit 50, only the differences will be explained hereinafter.

The heat-exchanger unit 50 employs the male coupler 60 and the male connector 68, whereas the central heat-exchanger unit 51 employs female ones.

More specifically, the central heat-exchanger unit 51 includes female couplers 98 extending from the lower shell 53 and the upper shell 54, respectively. As shown in Fig. 14, each female coupler 98 is in the form of a pipe, the internal diameter of which is substantially the same as the external diameter of the male coupler 60 of the above-described heat-exchanger unit 50.

The lower shell 53 of the central heat-exchanger unit 51 is provided with female connectors 100. As shown in Figs. 8 and 13A, each female connector 100 is in the form of a plate-like member 101 extending from the lower shell 53 in parallel thereto and has a hole 102 defined therein.

The manner in which the heat-exchanger units 50, 51, 52 are connected together and the relationship with other elements will be explained hereinafter.

In this embodiment, the heat-exchanger units 50, 51, 52 are connected in series with each other, as described previously. More specifically, between the heat-exchanger units 50 and 51, and between the heat-exchanger units 51 and 52, the pins 73 of the male connectors 68 are engaged in the corresponding holes 102 of the female connectors 100 to thereby connect the heat-exchanger units 50, 51, 52 together. Also, between the heat-exchanger units 50 and 51, and between the heat-exchanger units 51 and 52, the male couplers 60 are engaged in the corresponding female couplers 98 so that the cavities formed by the lower shells 53 of the heat-exchanger units 50, 51, 52 for the passage of a heat transfer medium are connected in series, while those formed by the upper shells 54 of the heat-exchanger units 50, 51, 52 for the passage of another heat transfer medium are similarly connected in series.

One of the male couplers 60 of the lower shell 53 of the heat-exchanger unit 50 and one of the male couplers 60 of the lower shell 53 of the heat-exchanger unit 52 are connected to the hot-side piping system 2. On the other hand, one of the male couplers 60 of the upper shell 54 of the heat-exchanger unit 50 and one of the male couplers 60 of the upper shell 54 of the heat-exchanger unit 52 are connected to the cold-side piping system 3.

In the cold-side piping system 3, as shown by the arrows in Fig. 5, the heat transfer medium enters the right-hand side flow passage 70, defined in the heat-exchanger unit 50, through the male coupler 60 of the upper shell 54 of the heat-exchanger unit 50 and then flows through the cavity, defined between the surface of the turbulator 55 and the heat transfer surface 81 of the thermoelectric module 5, before the heat transfer medium enters the left-hand side flow passage 71. In this embodiment, because the obstacles, i.e. , the projections 82 and the baffles 79 are formed in each of the groove-shaped flow passages 84 formed on the turbulator 55, the heat transfer medium impinges on these obstacles and is then prevented by the groove-shaped flow passages from flowing in a direction widthwise of the turbulator, thus generating streams that are brought into direct contact with the thermoelectric module 5. Because of this, the heat transfer medium impinges on the heat transfer surface 81 of the thermoelectric module 5 in a direction perpendicular thereto, resulting in an efficient heat exchange.

Having passed through the turbulator 55, the heat transfer medium enters the left-hand side flow passage and then flows towards the heat-exchanger unit 51 via the male coupler 60. The heat transfer medium then enters the left-hand side flow passage 71 of the heat-exchanger unit 51 via the female coupler 98 and then flows therethrough in a manner similar to the above. Thereafter, the heat transfer medium enters and flows through the right-hand side flow passage 70, then enters the heat-exchanger unit 52 via the female coupler 98 of the heat-exchanger unit 51 and the male coupler 60 of the heat-exchanger unit 52, and eventually goes out via the male coupler 60 positioned on the opposite side.

Because the heat transfer medium flows through the hot-side piping system 2 in the same manner as in the cold-side piping system 3, no further description thereof will be made for the sake of brevity.

In the refrigerator 30 according to this embodiment, because the lower shell 53, the upper shell 54 and the turbulators 55 are all transparent or semi-transparent, the heat transfer surfaces 80, 81 of the thermoelectric module 5 can be observed from outside. Accordingly, the state of flow of the heat transfer medium can be well recognized from outside and, hence, entry of air, clogging by foreign substances or the like can be found out at first glance.

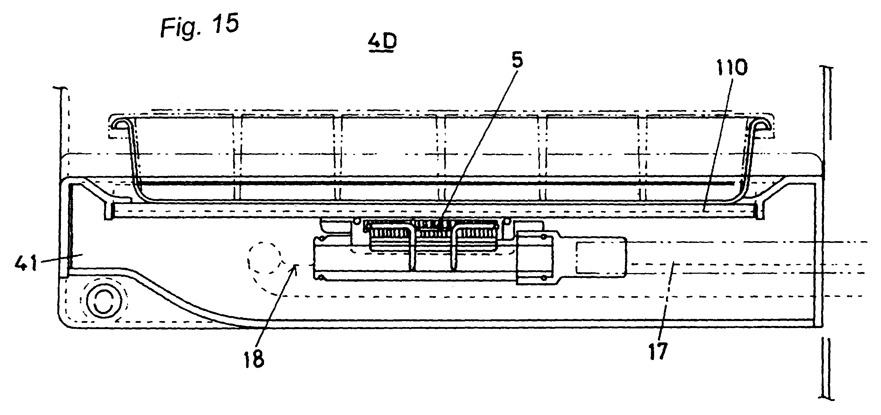

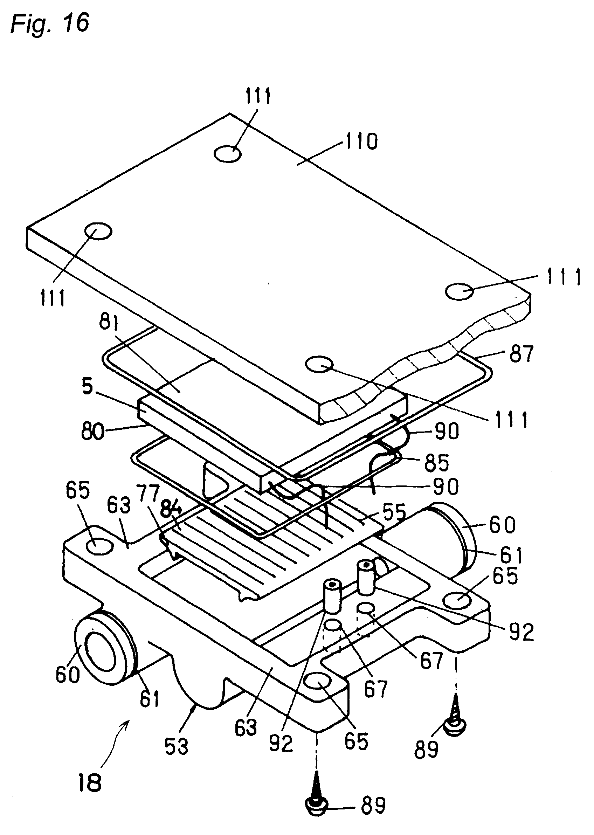

The ice-making heat-exchanger unit 18 will now be described with reference to Figs. 15 and 16.

Briefly speaking, the ice-making heat-exchanger unit 18 is substantially similar to the above-described heat-exchanger unit 50, except that the upper shell 54 of the heat-exchanger unit 50 is replaced with a cooling plate 110. As shown in Figs. 15 and 16, the cooling plate 110 is a metallic plate made of, for example, aluminum having a superior heat conductivity and has holes 111 defined therein at locations corresponding those of the screw holes 75 of the upper shell 54. In the ice-making heat-exchanger unit 18, the cooling plate 110 is screwed to the lower shell 53, and the rear surface of the cooling plate 110 is held in direct contact with the cold-side heat transfer surface 81 of the thermoelectric module. Also in the ice-making heat-exchanger unit 18, a ring-shaped sealing member 87 is interposed between the lower shell 53 and the cooling plate 110 to prevent the heat transfer medium from leaking from the heat-exchanger unit 18 itself.

The ice-making heat-exchanger unit 18 has a cavity defined therein, into which a cooled heat transfer medium flows via the bypass piping 17. Accordingly, the heating-side heat transfer surface 80 of the thermoelectric module 5 in the ice-making heat-exchanger unit 18 is cooled by such heat transfer medium and, hence, the opposite cold-side heat transfer surface 81 is further reduced in temperature.

Therefore, when an ice chipper tray (an object to be cooled) 115 is placed on the cooling plate 110, water contained therein freezes into ice.

Another embodiment of the present invention will be explained hereinafter, wherein although the use of transparent or semi-transparent shells is preferred, non-transparent or non-semi-transparent shells can be used.

Although in the above-described embodiment the heat-exchanger units 50, 51, 52 employ a combination of the pins 73 and the holes 102 as connecting means, the mutual connection thereof may be accomplished using hooks 119 as shown in Fig. 13B.

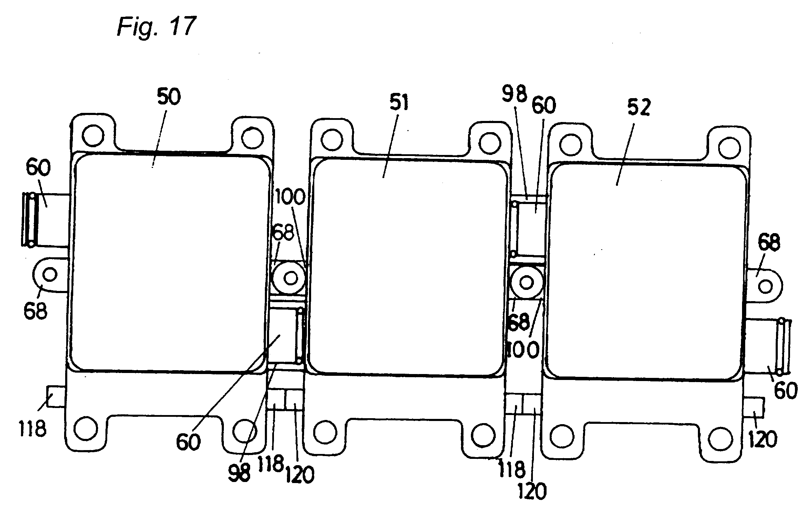

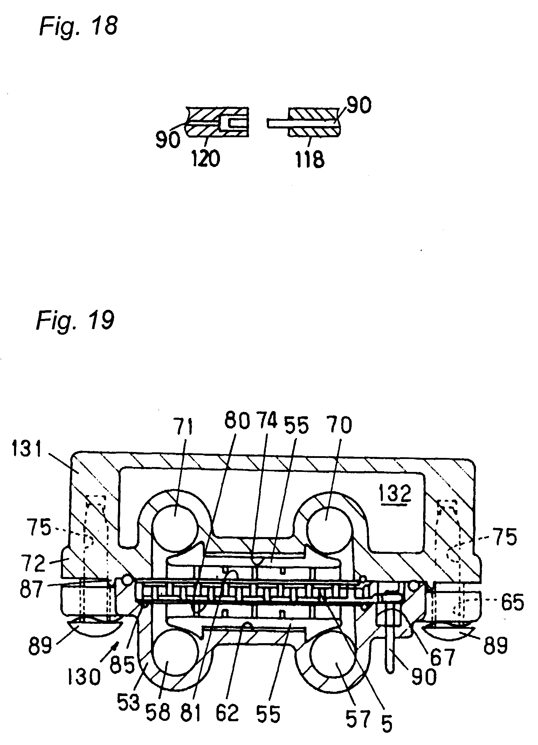

Also, although in the above-described embodiment the lead wires 90 of the thermoelectric module 5 are led outside directly through the corresponding lead-wire holes 67, they can be led outside through connectors 118, 120 mounted on the lower shell 118 or the upper shell 54 (see Figs. 17 and 18).

Particularly, in the application where a plurality of heat-exchanger units each having a thermoelectric module 5 are provided as in the above-described embodiment, because the thermoelectric modules 5 are preferably connected in series, it is desired that the lower shells 53 are directly connected together via male and female connectors 118, 120 mounted on the end surfaces of the lower shells 53.

If the interval for connection of the male connector 68 and the female connector 100, the interval for connection of the male coupler 60 and the female coupler 98, and the interval for connection of the connectors 118, 120 are made equal, the mechanical connection, the piping connection, and the electrical connection of the heat-exchanger units can be accomplished through one operation, enhancing workability during assemblage.

Figs. 17 and 18 depict the case wherein the lower shells 53 are mutually connected through the male and female connectors directly mounted thereon.

More specifically, each of the end heat-exchanger units 50, 52 has the male connectors 118 mounted on respective opposite ends thereof, while the central heat-exchanger unit 51 has the female connectors 120 mounted on respective opposite ends thereof, with one of the lead wires 90 of each thermoelectric module 5 connected to each of the connectors 118, 120 of the heat-exchanger units 50, 51, 52. By this construction, the neighboring heat-exchanger units can be connected together via the male and female connectors 118, 120.

According to this embodiment, not only the piping connection but the electrical connection can be accomplished merely by connecting the heat-exchanger units 50, 51, 52, facilitating assemblage of the refrigerator 30.

A further embodiment of the present invention will be explained hereinafter with reference to Fig. 19.

A heat-exchanger unit 130 as shown in Fig. 19 is intended to enhance the heat insulating properties. The heat-exchanger unit 130 is used in the case where either the lower shell 53 or the upper shell 54 requires heat insulation. More specifically, as is the case with the above-described embodiment, if the heat-exchanger unit is placed outside the storage compartment, it is necessary to encircle the cooling-side shell with a heat insulating material to prevent leakage of cooled air. Conversely, if the heat-exchanger unit is placed inside the storage compartment, it is necessary to encircle the heating-side shell with a heat insulating material so that the storage compartment may not be filled with hot air.

However, the work required for encircling the shell with the heat insulating material is so complicated as to require skill, and there is the possibility that the shell may be partly exposed depending on the worker, resulting insufficient heat insulation.

To overcome this kind of problem, the heat-exchanger unit 130 shown in Fig. 19 employs a shell 131 having a hollow portion 132 defined therein on the rear side thereof that acts as a heat insulating layer.

More specifically, in the heat-exchanger unit 130, the substantially closed hollow portion 132 is formed on the rear side of the flange portions 63 and the wall portion 62, both described previously. Although the molding method of the shell 131 is not limited to a specific one, the substantially closed hollow portion 132 can be readily formed by, for example, blow molding.

Even if the hollow portion 132 is empty, a considerable heat insulating effect can be expected by air contained therein, but the heat insulating effect can be further enhanced by injecting expanded urethane or the like thereinto.

Although in the heat-exchanger unit shown in Fig. 19 the hollow portion 132 is provided on the rear side of only one shell 131, both the shells may be provided with respective hollow portions formed on the rear sides thereof.

Although the heat-exchanger unit assembly has been described as being of a triple in-line design, it may be of a design including two or four or more heat-exchanger units. Because the number of heat-exchanger units connected together can be changed depending on the capacity of the refrigerator, the heat-exchanger unit assembly of the present invention is applicable to refrigerators of any capacity, and the interchangeability of component parts is high.

Also, although in the above-described embodiments the heat-exchanger units are connected in series, they can be connected in parallel.

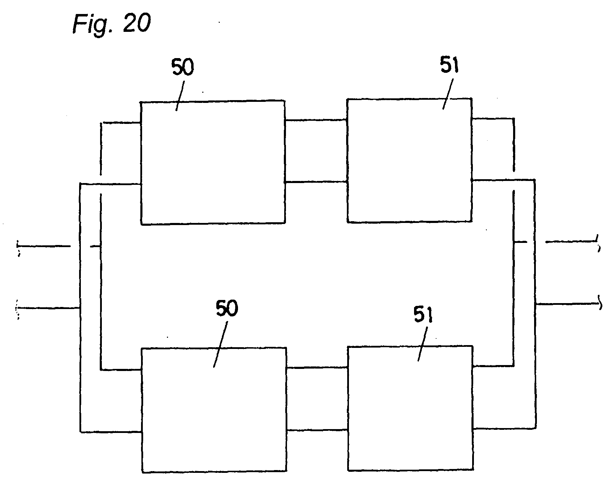

Fig. 20 depicts the case wherein the heat-exchanger units are used in parallel. In the embodiment shown in Fig. 20, two heat-exchanger unit assemblies are connected in parallel, while each of them includes two heat-exchanger units 50, 51 connected in series.

The parallel connection of the heat-exchanger units has the advantage of reducing the resistance to flow. Although the series connection of the heat-exchanger units has the disadvantage of losing the cooling ability by clogging of one heat-exchanger unit, the parallel connection can ensure the cooling ability to some degree. Accordingly, the maintenance can be somewhat extended and facilitated.

## Claims

1. A heat-exchanger unit with built-in thermoelectric module characterized in that it comprises a thermoelectric module having at least two heat transfer surfaces which are, when an electric current flows, heated and cooled, respectively, and a shell member for covering at least one of the heat transfer surfaces of the thermoelectric module to define, between it and such one of the heat transfer surfaces, a cavity for passage of a heat transfer medium therethrough, said shell member being transparent or semi-transparent.

2. A heat-exchanger unit characterized in that it comprises a thermoelectric module having at least two heat transfer surfaces which are, when an electric current flows, heated and cooled, respectively, a shell member for covering one of the heat transfer surfaces of the thermoelectric module that is heated, to thereby define a cavity for passage of a heat transfer medium therethrough between it and the heated heat transfer surface of the thermoelectric module, and a cooling plate held in contact with one of the heat transfer surfaces of the thermoelectric module which is cooled, said cooling plate being utilizable for the support thereon of an article to be cooled.

3. The heat-exchanger unit as claimed in Claim 2, characterized in that the cooling plate is replaceable with the shell member such that when the cooling plate is replaced with the shell member, the cavity for passage of the heat transfer medium therethrough can be defined adjacent each of the heat transfer surfaces.

4. The heat-exchanger unit as claimed in any one of Claims 1 to 3, characterized in that a sealing member is interposed between the shell member and the heat transfer surface to prevent leakage of the heat transfer medium from the cavity.

5. A heat-exchanger unit characterized in that it comprises a thermoelectric module having at least two heat transfer surfaces which are, when an electric current flows, heated and cooled, respectively, a shell member for covering at least one of the heat transfer surfaces of the thermoelectric module to define a cavity for passage of a heat transfer medium therethrough between it and such one of the heat transfer surfaces of the thermoelectric module, said shell member having a lead insertion hole defined therein in communication with the outside, and an elastic sealing member having a through-hole defied therein and inserted in the lead insertion hole, said thermoelectric module having a lead wire that is inserted through the through-hole in the elastic seal member so as to extend externally from the shell member, said elastic sealing member being compressed when the lead wire is passed therethrough, to thereby compress the lead insertion hole and the lead wire.

6. A heat-exchanger unit characterized in that it comprises a thermoelectric module having at least two heat transfer surfaces which are, when an electric current flows, heated and cooled, respectively, and a shell member for covering at least one of the heat transfer surfaces of the thermoelectric module to define a cavity for passage of a heat transfer medium therethrough, a hollow portion being integrally provided at a rear side of the cavity in the shell member.

7. The heat-exchanger unit as claimed in Claim 6, characterized in that a foam material is filled in the hollow portion.

8. A heat-exchanger unit assembly characterized in that it comprises a plurality of blocks each comprising a thermoelectric module having at least two heat transfer surfaces which are, when an electric current flows, heated and cooled, respectively, and a shell member for covering at least one of the heat transfer surfaces of the thermoelectric module to define a cavity for passage of a heat transfer medium therethrough, said shell member being provided with a tubular connector, said blocks being connected together with the tubular connector of the shell member of one of the blocks fluid-connected with the tubular connector of the shell member of the next adjacent one of the blocks to thereby define a continuous flow passage.

9. A heat-exchanger unit assembly characterized in that it comprises a plurality of blocks each comprising a thermoelectric module having at least two heat transfer surfaces which are, when an electric current flows, heated and cooled, respectively, and a shell member for covering at least one of the heat transfer surfaces of the thermoelectric module to define a cavity for passage of a heat transfer medium therethrough, said shell member being provided with an electric connector for connection with the thermoelectric module, said blocks being electrically connected with each other through the connectors.

10. The heat-exchanger unit assembly as claimed in Claim 9, characterized in that said shell member is provided with a tubular connector, said blocks being connected together with the tubular connector of the shell member of one of the blocks fluid-connected with the tubular connector of the shell member of the next adjacent one of the blocks to thereby define a continuous flow passage.

11. A heat-exchanger unit assembly characterized in that each of a plurality of blocks comprises a thermoelectric module having at least two heat transfer surfaces which are, when an electric current flows, heated and cooled, respectively, and a shell member for covering at least one of the heat transfer surfaces of the thermoelectric module to define a cavity for passage of a heat transfer medium therethrough, wherein the cavities in those blocks are fluid-connected parallel to each other.

12. A thermoelectric refrigerating system in which a heat-exchanger for refrigerating an article to be cooled, a pump for circulating a heat transfer medium and a first heat-exchanger unit having a first thermoelectric module built therein, said heat-exchanger, pump and first heat-exchanger unit being connected in a ring-shaped fashion, characterized in that there is provided a shell member for covering a heated heat transfer surface of a second thermoelectric module and for defining a cavity for passage of the heat transfer medium therethrough between it and the heated heat transfer surface of the second thermoelectric module, and a second heat-exchanger unit including a cooling plate held in contact with a cooled heat transfer surface of the second thermoelectric module for providing the article partly with a region of a low temperature.
